# EUROPEAN PATENT SPECIFICATION

(11) **EP 2 772 770 B1**
(45) Date of publication and mention of the grant of the patent: **23.09.2015**
(21) Application number: 13157280.2
(22) Date of filing: 28.02.2013
(51) Int. Cl.: G01R 31/34, H02H 3/17, H02H 7/06, H02H 7/08

(54) **Rotor earth fault protection for an electrical variable speed doubly fed induction machine**
Rotorerdungsfehlerschutz für eine doppelt eingespeiste Induktionsmaschine mit elektrisch variabler Drehzahl
Dispositif de protection contre les défauts de terre de rotor destiné à une machine à induction à double alimentation à vitesse variable électrique

(43) Date of publication of application: 03.09.2014
(73) Proprietor: ALSTOM Technology Ltd, 5400 Baden (CH)
(72) Inventor: Zou, LI, Stafford, Staffordshire ST16 1LL (GB); Lloyd, Graeme, Stafford, Staffordshire ST16 3HZ (GB)
(74) Representative: Ilgart, Jean-Christophe

(56) References cited:
- EP-A1- 2 530 801
- US-A- 4 224 652
- US-A- 4 667 262
- US-A- 5 739 693
- US-A1- 2011 085 272

## Description

### FIELD OF THE INVENTION

The field of the invention is that of protection of electrical variable speed doubly fed induction machines such as motors and generators. The invention more precisely relates to providing protection against earth faults on the rotor conductors of such machines.

### DESCRIPTION OF THE PRIOR ART

Doubly fed electric machines are electric motors or electric generators that have windings on both stationary and rotating parts. The stator winding is directly connected to the three-phase grid and the three-phase rotor winding is fed from the grid through a power electronic converter.

Earth fault protection for the rotor of a synchronous machine is typically provided by injecting a low frequency signal (typically 0.25 -1Hz) via the brush connections into the rotor and measuring the resistance to earth. Such a protection is for instance described in "Alstom P34x Generator Protection Relay User Manual (P34x/EN M/I96)".

The excitation circuit of a synchronous machine is unearthed and comprises a single winding forming a DC circuit, which is coupled to the rotor excitation system via the rotor brushes.

The rotor of a variable speed doubly fed induction machine is a 3 phase winding with a 3 phase slip ring assembly with brushes for access to the rotor winding. The slip ring assembly requires maintenance and there are reliability issues with connecting the rotor earth fault protection via the slip rings.

Also, the conventional synchronous machine rotor earth fault protection is not designed to inject a signal into a 3 phase winding.

Moreover, the rotor frequency during normal running of a variable speed doubly fed induction machine is very low (typically 0.1Hz - 6Hz) so the typical synchronous machine rotor earth fault protection injection frequencies interfere with the rotor frequency.

It thus appears that existing rotor earth fault protection for DC excitation of synchronous machines cannot be used for a three phase winding of a variable speed rotor.

Stator earth fault protection for synchronous machines, such as the one described in US patent 5,508,620, also relies on an injection principle. As the three phase rotor of a variable speed doubly fed induction machine is similar to the three phase stator winding, in principle the stator injection method of earth fault protection could be used for the rotor earth fault protection. However, stator earth fault protection needs an earth point while the rotor of a variable speed doubly fed induction machine is normally unearthed and the star point of the rotor windings is normally inaccessible. Further prior art is presented in EP2530801, US5739693, US4667262, US2011/085272 and US4224652.

### SUMMARY OF THE INVENTION

The invention aims at providing a protection against rotor earth faults that would otherwise damage variable speed doubly fed induction machines. To this purpose, the invention provides a protection system for an electrical variable speed doubly fed induction machine having a multi-phase rotor, comprising star-connected resistors, one end of each resistor being connected to a respective phase of the rotor and the other end of the resistors being commonly connected to provide an artificial neutral point, and an earthing and injection circuit connected to said artificial neutral point to perform voltage injection.

Certain preferred but not limiting features of this system are as follows:
- the earthing and injection circuit comprises an earthing resistance arranged between the artificial neutral point and earth, and a signal generator connected across the earthing resistance via a transformer;
- the earthing and injection circuit further comprises a bandpass filter;
- the signal generator generates an injection signal with a frequency which is higher than the rotor slip frequency range during running;
- the resistance value Rc of the star connected resistors and the resistance value R_{N} of the earthing resistor satisfy the following condition: Rc + 3 x R_{N} < 2 / Cw where C is the total phase-to-earth capacitance of the rotor earth fault protection module and w is 2πf, where f is the frequency of the signal generated by the signal generator;
- it further comprises a rotor earth fault protection module configured to calculate a rotor to earth resistance from measurements of a fault current caused by a rotor earth fault and of the injected voltage;
- the rotor earth fault protection module connects to a current transformer to measure the fault current;
- the injected voltage is measured at the secondary of the transformer;
- the rotor earth fault protection module comprises a bandpass filter to filter out the rotor frequency component in the rotor signals.

The invention is defined in the appended claims.

### DESCRIPTION OF THE DRAWINGS

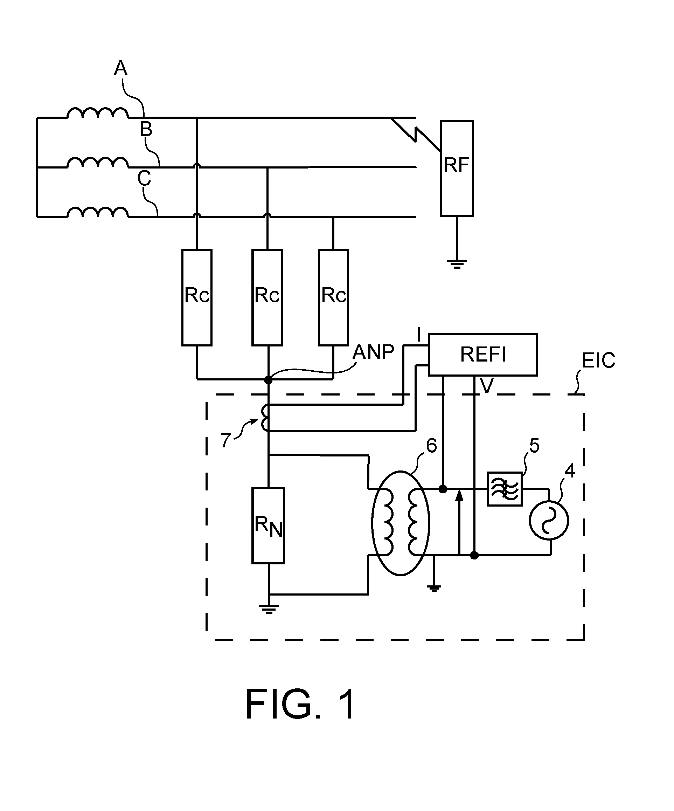

Other aspects, goals, advantages and features of the invention will appear more clearly on reading the following detailed description of preferred embodiments thereof, given by way of non-limiting example and with reference to the accompanying drawing in which figure 1 is a diagram showing a rotor earth fault protection according to a possible embodiment of the invention.

### DESCRIPTION OF PREFERRED EMBODIMENTS

The invention relates to a rotor earth fault protection system for an electrical variable speed doubly fed induction machine (motor or generator). The induction machine has windings on both the stator and the rotor. The n-phase (with n being typically three) stator winding is directly connected to a n-phase grid and the n-phase rotor winding is fed from the grid through a power electronic converter which conventionally comprises a grid side converter, a DC link and a rotor side converter.

The rotor earth fault protection system of the invention uses a frequency injection technique that detects earth faults in the entire winding, including the rotor neutral point. Under normal healthy conditions only a very small current flows via the rotor earth capacitance due to the high impedance of this path at the injected frequency (Xc = 1/2πfc). In the event of an earth fault the current increases and the resistance to ground decreases due to the smaller impedance of the earth fault path. From the injected voltage and the measured fault current, the protection system can determine the fault resistance. The protection system can also detect earth faults at the rotor terminals including connected components. From the measured current and voltage vectors the complex impedance can be calculated and from this the ohmic resistance is determined. This eliminates disturbances caused by the rotor earth capacitance and ensures high sensitivity. The algorithm for calculating the fault resistance can compensate for angle error and series resistance and parallel resistance. Angle errors, series resistance and parallel resistance values can be measured during the commissioning tests and entered into the settings. Rotor earth fault protection can be provided with under resistance and overcurrent protection modules using the calculated fault resistance and measured circulating fault current. Multiple stages can be used to trigger an alarm and trip a circuit breaker.

With reference to figure 1, the rotor comprises three phases A, B, C. In the event of an earth fault, a fault current may flow to earth whose magnitude depends on the fault position and fault resistance. Given the measured injected voltage and the measurement of the circulating current at the injected frequency, a rotor-to-earth fault resistance RF can be calculated, the magnitude of which can be used to assess the fault.

Still with reference to figure 1, the rotor earth fault protection system of the invention comprises star-connected resistors Rc, one end of each resistor being connected to a respective phase A, B, C of the rotor and the other end of the resistors being commonly connected to provide an artificial neutral point ANP.

The star-connected resistors Rc are preferably sized large enough to reduce the load current from the rotor to reduce losses.

The protection system further comprises an earthing and injection circuit EIC connected to said artificial neutral point ANP to perform voltage injection into the artificial neutral point.

The earthing and injection circuit EIC comprises an earthing resistor R_{N} between the artificial neutral point and ground. 100% rotor earth fault protection can thereby be provided by injecting into the artificial star point of the rotor an external frequency alternating voltage, such as a square-wave voltage, generated by a frequency signal generator 4 of the earthing and injection circuit EIC.

In the earthing and injection circuit EIC, the output of the frequency signal generator 4 is connected via a bandpass filter 5 across the earthing resistor R_{N} via an earthing transformer 6.

If an earth fault occurs in the rotor windings, the injected voltage drives a rotor to earth current (fault current) through the earthing resistance R_{N}. A rotor earth fault protection module REFI measures the fault current from a current transformer 7 to which the REFI module is connected and the injected voltage from the secondary of the earthing transformer 6. From the injected voltage and the fault current, the REFI module can calculate the rotor-to-earth fault resistance RF.

The signal injection frequency is chosen so as not to cause any interference problem with the normal rotor slip frequency. An injection frequency higher than the typical rotor slip frequency range during running (typically 0.1Hz to 6Hz), such as a frequency of 20 Hz, is considered to be suitable. The rotor frequency is between nominal power system frequency (50Hz or 60Hz) and rotor slip frequency when the machine is starting up and braking.

The bandpass filter 5 provides rounding of the square-wave voltage generated by signal generator 4 and energy storage. The high series resistance of the bandpass filter 5 further protects the injection generator 4 from excessive feedback current if the earthing resistor R_{N} carries the full displacement voltage during a terminal phase-earth fault.

The earthing resistor R_{N} is connected in parallel with the low frequency generator 4 to generate a defined neutral current in normal healthy conditions. The voltage to be injected into the artificial star point depends on the driving injection voltage and on the transformation ratio of the earthing transformer 6. The earthing transformer VA rating is sized large enough to avoid saturation.

In order to limit the transient overvoltage during rotor earth fault conditions, the resistances values R_{N} and Rc shall satisfy the following condition: Rc + 3 x R_{N} < 2 / Cw where C is the total phase-to-earth capacitance of the injection circuit and w is 2πf, where f is the frequency of the injected voltage.

In an embodiment, the rotor earth fault protection module REFI comprises a bandpass filter to filter out the rotor frequency component and PWM frequency components in the rotor signals. For stator earth fault applications such a bandpass filter is automatically enabled only during the machine start-up. For rotor earth fault applications in accordance with the invention, this filter is preferably permanently enabled to provide better filtering of the higher distortion of the rotor signals.

As the earth fault protection is an important protection function for the rotor, and in order to achieve maximum protection availability, redundancy can be introduced into the design using duplicated frequency injection generators 4. The backup (hot standby) generator can be switched on in the event the first generator fails, thereby achieving dependability. Only one signal can be injected at a time as otherwise there will be interference between the two generators. An automatic switchover scheme can be implemented where the backup injection generator can be engaged upon detection of failure of the first injection generator, using the watchdog contacts provided by the injection generator or an injection signal supervision function provided by a protection relay.

The protection system described above has the following advantages.

Variable speed doubly fed induction motors and generators are protected from damaging rotor earth faults during machine normal running, start-up and braking.

The rotor earth fault protection scheme protects 100% of the rotor winding.

Maximum rotor earth fault protection availability is achieved with hot standby of the injection generator.

The invention is not limited to the above-described protection system, but also extends to a method of providing rotor earth fault protection in an electrical variable speed doubly fed induction machine, comprising star-connecting resistors, one end of each resistor being connected to a respective phase of the rotor and the other end of the resistors being commonly connected to provide an artificial neutral point, and injecting a low frequency signal at said artificial neutral point via an earthing resistor.

## Claims

1. A protection system for an electrical variable speed doubly fed induction machine having a multi-phase rotor, the system comprising star-connected resistors (Rc), one end of each resistor being connected to a respective phase of the rotor and the other end of the resistors being commonly connected to provide an artificial neutral point (ANP), and an earthing and injection circuit (EIC) connected to said artificial neutral point to perform voltage injection.

2. The protection system of claim 1, wherein the earthing and injection circuit (EIC) comprises an earthing resistance (R_{N}) arranged between the artificial neutral point and earth, and a signal generator (4) connected across the earthing resistance via a transformer (6).

3. The protection system of claim 2, wherein the earthing and injection circuit (EIC) further comprises a bandpass filter (5).

4. The protection system of claim 2, wherein the signal generator (4) generates an injection signal with a frequency which is higher than the rotor slip frequency range during running.

5. The protection system of claim 2, wherein the resistance value Rc of the star connected resistors and the resistance value R_{N} of the earthing resistor satisfy the following condition: Rc + 3 x R_{N} < 2 / Cw where C is the total phase-to-earth capacitance of the rotor earth fault protection module and w is 2πf, where f is the frequency of the signal generated by the signal generator.

6. The protection system of claim 2, further comprising a rotor earth fault protection module (REFI) configured to calculate a rotor to earth resistance (RF) from measurements of a fault current caused by a rotor earth fault and of the injected voltage.

7. The protection system of claim 6, wherein the rotor earth fault protection module (REFI) connects to a current transformer to measure the fault current.

8. The protection system of claim 6, wherein the injected voltage is measured at the secondary winding of the transformer (6).

9. The protection system of claim 6, wherein the rotor earth fault protection module (REFI) comprises a bandpass filter to filter out the rotor frequency component in the rotor signals.

10. A method for rotor earth fault protection in an electrical variable speed doubly fed induction machine, the method provides a protection system comprising star-connecting resistors (Rc), one end of each resistor being connected to a respective phase of the rotor and the other end of the resistors being commonly connected to provide an artificial neutral point (ANP), and further provides voltage injection at said artificial neutral point.

## Patentansprüche

1. Schutzsystem für eine doppelt gespeiste elektrische Induktionsmaschine mit variabler Geschwindigkeit, die einen Multiphasenrotor aufweist, wobei das System sternförmig verbundene Widerstände (Rc) umfaßt, wobei ein Ende jedes Widerstands mit einer jeweiligen Phase des Rotors verbunden ist, und das andere Ende der Widerstände gemeinschaftlich verbunden ist, um einen künstlichen Neutralpunkt (ANP) bereitzustellen, und wobei eine Erdungs- und Injektionsschaltung (EIC) mit dem künstlichen Neutralpunkt verbunden ist, um eine Spannungsinjektion zu bewirken.

2. Schutzsystem nach Anspruch 1, wobei die Erdungs- und Injektionsschaltung (EIC) einen Erdungswiderstand (R_{N}) umfaßt, der zwischen dem künstlichen Neutralpunkt und Erde angeordnet ist, sowie einen Signalgenerator (4), der mittels eines Transformators (6) über den Erdungswiderstand verbunden ist.

3. Schutzsystem nach Anspruch 2, wobei die Erdungs- und Injektionsschaltung (EIC) ferner ein Bandpaßfilter (5) umfaßt.

4. Schutzsystem nach Anspruch 2, wobei der Signalgenerator (4) ein Injektionssignal mit einer Frequenz generiert, die höher ist als die Rotorschlupffrequenz im Betrieb.

5. Schutzsystem nach Anspruch 2, wobei der Widerstandswert Rc der sternförmig verbundenen Widerstände und der Widerstandswert R_{N} des Erdungswiderstands die folgende Bedingung erfüllen: Rc + 3 x R_{N} < 2/Cw, wobei C die gesamte Phase-Erde-Kapazität des Rotor-Erde-Fehlerschutzmoduls ist, und w 2πf ist, wobei f die Frequenz des vom Signalgenerator generierten Signals ist.

6. Schutzsystem nach Anspruch 2, ferner umfassend ein Rotor-Erde-Fehlerschutzmodul (REFI), das dazu ausgelegt ist, einen Rotor-zu-Erde-Widerstand (RF) aus Messungen eines Fehlerstroms zu berechnen, der durch einen Rotor-Erde-Fehler verursacht wird, und der injizierten Spannung.

7. Schutzsystem nach Anspruch 6, wobei das Rotor-Erde-Fehlerschutzmodul (REFI) zur Messung des Fehlerstroms mit einem Stromtransformator verbunden ist.

8. Schutzsystem nach Anspruch 6, wobei die injizierte Spannung an der Sekundärwicklung des Transformators (6) gemessen wird.

9. Schutzsystem nach Anspruch 6, wobei das Rotor-Erde-Fehlerschutzmodul (REFI) ein Bandpaßfilter umfaßt, um die Rotorfrequenzkomponente in den Rotorsignalen auszufiltern.

10. Verfahren zum Rotor-Erde-Fehlerschutz in einer doppelt gespeisten elektrischen Induktionsmaschine mit variabler Geschwindigkeit, wobei das Verfahren ein Schutzsystem bereitstellt, umfassend sternförmig verbundene Widerstände (Rc), wobei ein Ende jedes Widerstands mit einer jeweiligen Phase des Rotors verbunden ist, und das andere Ende der Widerstände gemeinschaftlich verbunden ist, um einen künstlichen Neutralpunkt (ANP) bereitzustellen, und ferner eine Spannungsinjektion an dem künstlichen Neutralpunkt bereitstellt.

## Revendications

1. Système de protection pour une machine électrique à induction à double alimentation à vitesse variable ayant un rotor multiphase, le système comprenant des résistors connectés en étoile (Rc), une extrémité de chaque résistor étant connectée à une phase respective du rotor et l'autre extrémité des résistors étant connectée de façon commune pour fournir un point neutre artificiel (ANP), et un circuit de mise à la terre et d'injection (EIC) connecté audit point neutre artificiel pour réaliser une injection de tension.

2. Système de protection selon la revendication 1, dans lequel le circuit de mise à la terre et d'injection (EIC) comprend une résistance de mise à la terre (R_{N}) agencée entre le point neutre artificiel et la terre, et un générateur de signal (4) connecté aux bornes de la résistance de mise à la terre via un transformateur (6).

3. Système de protection selon la revendication 2, dans lequel le circuit de mise à la terre et d'injection (EIC) comprend en outre un filtre passe-bande (5).

4. Système de protection selon la revendication 2, dans lequel le générateur de signal (4) génère un signal d'injection ayant une fréquence qui est plus élevée que la plage de fréquences de glissement de rotor pendant le fonctionnement.

5. Système de protection selon la revendication 2, dans lequel la valeur de résistance Rc des résistors connectés en étoile et la valeur de résistance R_{N} du résistor de mise à la terre satisfont la condition suivante : Rc + 3 x R_{N} < 2/Cw où C est la capacité totale phase-terre du module de protection de défaut à la terre de rotor et w est 2πf, où f est la fréquence du signal généré par le générateur de signal.

6. Système de protection selon la revendication 2, comprenant en outre un module de protection de défaut à la terre de rotor (REFI) configuré pour calculer une résistance rotor-terre (RF) à partir de mesures d'un courant de défaut provoqué par un défaut à la terre de rotor et de la tension injectée.

7. Système de protection selon la revendication 6, dans lequel le module de protection de défaut à la terre de rotor (REFI) se connecte à un transformateur de courant pour mesurer le courant de défaut.

8. Système de protection selon la revendication 6, dans lequel la tension injectée est mesurée au niveau de l'enroulement secondaire du transformateur (6).

9. Système de protection selon la revendication 6, dans lequel le module de protection de défaut à la terre de rotor (REFI) comprend un filtre passe-bande pour éliminer par filtrage la composante de fréquence de rotor dans les signaux de rotor.

10. Procédé de protection de défaut à la terre de rotor dans une machine électrique à induction à double alimentation à vitesse variable, le procédé assure un système de protection comprenant des résistors à connexion en étoile (Rc), une extrémité de chaque résistor étant connectée à une phase respective du rotor et l'autre extrémité des résistors étant connectée de façon commune pour fournir un point neutre artificiel (ANP), et fournit en outre une injection de tension au niveau dudit point neutre artificiel.
